(19) Europäisches Patentamt / European Patent Office / Office européen des brevets

(11) **EP 4 667 619 A1**

(12) **EUROPEAN PATENT APPLICATION**

(43) Date of publication:
24.12.2025 Bulletin 2025/52

(21) Application number: 25182049.4

(22) Date of filing: **11.06.2025**

(51) International Patent Classification (IPC):
*C23C 28/04* (2006.01)   *B26B 21/60* (2006.01)
*C23C 14/06* (2006.01)   *C23C 16/32* (2006.01)
*C23C 16/38* (2006.01)   *C23C 30/00* (2006.01)
*C23C 28/00* (2006.01)

(52) Cooperative Patent Classification (CPC):
**C23C 28/044; B26B 21/60; C23C 14/0635;**
**C23C 14/067; C23C 16/32; C23C 16/38;**
**C23C 28/04; C23C 28/42; C23C 28/44;**
**C23C 30/005**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **18.06.2024   KR 20240079142**
**13.11.2024   KR 20240160864**

(71) Applicant: **Dorco Co., Ltd.**
**Seoul 06266 (KR)**

(72) Inventors:
• **PARK, Min Joo**
**06266 Seoul (KR)**
• **JUNG, Hyun Kyu**
**06266 Seoul (KR)**

(74) Representative: **Michalski Hüttermann & Partner**
**Patentanwälte mbB**
**Kaistraße 16A**
**40221 Düsseldorf (DE)**

(54) **RAZOR BLADE**

(57)    The present disclosure relates to a razor blade including: a blade substrate having a blade edge formed therein; and a coating layer formed on the blade substrate, wherein the coating layer contains a matrix-forming atom, a first atom, and a second atom, the coating layer contains a first coating region and a second coating region located at different depths in the thickness direction, and the second coating region has a larger number of nanocrystal regions than the first coating region.

FIG. 5

**Description**

**BACKGROUND**

Field

The present disclosure relates to a razor blade including a coating layer in which a first coating region and a second coating region having different properties are alternately positioned along the thickness direction.

Description of Related Art

In general, a razor blade includes a blade substrate made of stainless steel, ceramic, etc., and one or more coatings formed on the blade substrate. These coatings include a hard coating that forms the overall silhouette of the razor blade and enhances the durability of the razor blade, a lubricating coating that provides lubrication to prevent skin damage during shaving, and/or an interlayer coating that supplements the adhesive force between the substrate and the coating or between the coatings.

In the past, coatings of razor blades have been formed by a method of adding separate layers to perform each role rather than attempting to adjust the internal characteristics of the thin film that constitutes the coatings. This conventional technology resulted in various problems such as the occurrence of cracks between the coatings, an increase in the number of steps in the process, and an increase in the complexity of control to achieve stable adhesive force.

[Patent Document]

Korean Patent Registration No. 10-2211395

**SUMMARY**

The present disclosure relates to a razor blade including a coating layer in which a first coating region and a second coating region having different properties are alternately positioned along the thickness direction.

The object of the present disclosure is achieved by a razor blade including: a blade substrate having a blade edge formed therein; and a coating layer formed on the blade substrate, wherein the coating layer contains a matrix-forming atom, a first atom, and a second atom, the coating layer contains a first coating region and a second coating region located at different depths in the thickness direction, and the second coating region has larger area of nanocrystal regions than the first coating region.

The first coating region has superior adhesive force compared to the second coating region, and the second coating region may have superior strength compared to the first coating region.

The matrix-forming atom may include at least one of Cr, Ti, Mo, and W, the first atom may include at least one of C, B, N, and O, and the second atom may include at least one of C, B, N, and O.

The first atom and the second atom may be the same element.

The first atom and the second atom are different elements. The first coating region may contain more moles of the first atom than of the second atom, and the second coating region may contain more moles of the second atom than of the first atom.

At least one of the first coating region and the second coating region may comprise two regions spaced apart from each other, and the first coating region and the second coating region may be alternately arranged.

Each of the first coating region and the second coating region may comprise at least two regions spaced apart from each other.

One of the first coating region may be formed closest to the blade substrate among the other first coating region and the second coating region.

In the first coating region, the number of moles of first atoms may be 1.5 to 8 times that of the second atoms, and in the second coating region, the number of moles of second atoms may be 2 to 15 times that of the first atoms.

In the first coating region, the number of moles of first atoms may be 2 to 4 times that of the second atoms, and in the second coating region, the number of second atoms may be 4 to 12 times that of the first atoms on a molar basis.

The amount of the matrix-forming atom may be 1.2 to 1.8 times higher in the first coating region than in the second coating region on a molar basis.

The second coating region may have 3 to 50 times more nanocrystals than the first coating region.

The first coating region may comprise plural regions spaced apart from each other, and the thickness of the first coating region adjacent to the blade substrate may be 1.8 to 2.5 times the thickness of the second coating region that is in contact with the first coating region adjacent to the blade substrate.

The first coating region is located at an outermost part of the coating layer, and the thickness of the first coating region located at the outermost part of the coating layer may be 0.1 to 0.5 times the thickness of the first coating region located inside the coating layer.

The razor blade may further include a lubricating layer formed on the first coating region at the outermost part of the coating layer.

The matrix-forming atom may include Cr, the first atom may include C, and the second atom may include B.

The coating layer has an aspect ratio of 1:1.8 to 1:2.6, and the aspect ratio may be defined as thickness of the coating layer at a distance 1 $\mu$m from the tip of the blade substrate to distance from the tip of the blade substrate to the tip of the coating layer.

The thickness of the coating layer at a distance of 1 $\mu$m from the tip of the blade substrate may be 300 nm to 500 nm.

The above object of the present disclosure is achieved by a razor blade including: a blade substrate having a blade edge formed therein; and a coating layer formed on the blade substrate, wherein the coating layer contains a matrix-forming atom, a first atom, and a second atom, the coating layer contains a first coating region and a second coating region which are positioned at different depths in the thickness direction, the matrix-forming atom includes Cr, the first atom includes C, the second atom includes B, the first coating region contains more moles of the first atom than the second atom, and the second coating region contains more moles of the second atom than the first atom based on the mole number.

The object of the present disclosure is achieved by a razor blade including: a blade substrate having a blade edge formed therein; and a coating layer formed on the blade substrate, wherein the coating layer contains a first coating region and a second coating region positioned at different depths in the thickness direction, the first coating region has superior adhesive force compared to the second coating region, and the second coating region has superior strength compared to the first coating region.

The object of the present disclosure is achieved by a razor blade including: a blade substrate having a blade edge formed therein; and a coating layer formed on the blade substrate, wherein the coating layer contains a matrix-forming atom, a first atom, and a second atom, the first atom and the second atom are different, the coating layer has a first surface adjacent to the blade substrate and a second surface spaced apart from the blade substrate, the amount of the first atom and the second atom change along a thickness direction of the coating layer directing from the first surface toward the second surface, and the maximum content position of the first atom and the maximum content position of the second atom do not overlap.

The amount of the first atom and the second atom may gradually change along the thickness direction of the coating layer.

According to the present disclosure, a razor blade is provided including a coating layer in which a first coating region and a second coating region having different properties are alternately positioned along a thickness direction.

## BRIEF DESCRIPTION OF THE DRAWING

FIG. 1 shows a cross-sectional view of a razor blade according to one embodiment of the present disclosure,

FIGS. 2 to 5 show various cross-sections of a coating layer according to one embodiment of the present disclosure,

FIG. 6 shows distributions of the first and second atoms in the coating layer shown in FIG. 5,

FIG. 7 shows a distribution of nanocrystals in the coating layer shown in FIG. 5,

FIG. 8 shows compositions of coating layers of Examples prepared in Experimental Examples,

FIG. 9 shows atomic concentrations of major atoms according to the thickness of the coating layer of Example 2,

FIG. 10 shows crack occurrence mechanisms in the coating layers,

FIG. 11 shows atomic distributions in the coating layer of Example 4,

FIG. 12 shows a nanocrystal distribution in the coating layer of Example 4, and

FIGS. 13A to 13C show results of a performance test of a razor blade.

**DETAILED DESCRIPTION**

The present disclosure is intended to solve the problems of the prior art by including plural regions with different material compositions and/or properties in a hard coating layer (or coating layer) along the thickness direction.

The case where the coating layer is formed as a single region is explained as follows.

Since a chromium coating has excellent adhesive force, it may be used in the process of performing coating between a blade substrate and a lubricating layer (PTFE or the like). The chromium coating has low durability. In addition, since the chromium coating grows in a direction, it has high crystallinity, making it difficult to control the edge shape, and can only be formed with a thin thickness (about 50 nm or less).

The chromium carbon (CrC) coating may supplement the problems of the chromium coating by suppressing crystallinity and forming an amorphous thin film by containing carbon in the chromium coating. Since some of the contained carbons have an SP3 bond like diamonds, durability is improved, and since they are amorphous, it becomes easy to control edge shape. In addition, the adhesive force of the chromium coating is also maintained. However, in the recent trend of blade substrates gradually becoming thinner, the durability of the chromium carbon coating may not be sufficient.

Since a chromium boron (CrB) coating contains boron, some CrB nanocrystals are formed to have improved hardness. However, since it has high crystallinity compared to the chromium carbon coating, there are problems in that it is difficult to control an edge shape, and it is easy to break due to high brittleness.

The coating layer of the present disclosure has plural coating regions with different characteristics formed so that the cutting force may be improved by controlling the edge shape while satisfying the adhesive force and durability.

Hereinafter, the present disclosure will be described with reference to the drawings.

In the drawings below, the size, thickness, etc. of each component are illustrated as examples or arbitrarily, and the present disclosure is not limited thereto.

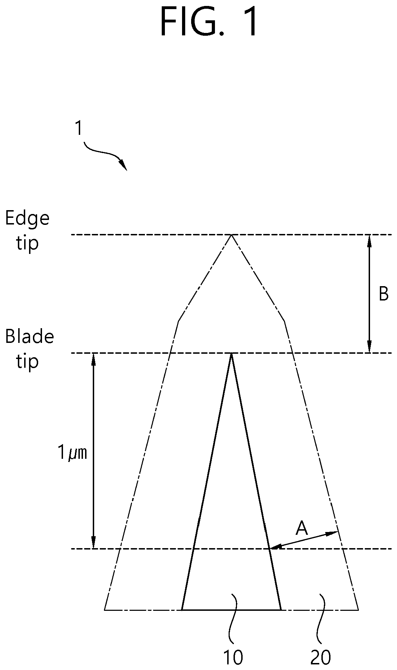

FIG. 1 is a cross-sectional view of a razor blade according to one embodiment of the present disclosure. FIG. 1 shows a blade edge and a coating layer formed on the blade edge in the razor blade.

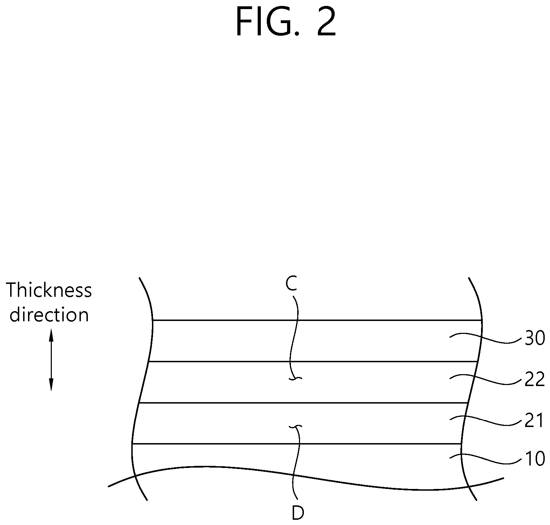

The razor blade 1 includes a blade substrate 10, a coating layer 20, and a lubricating layer (30, see FIG. 2).

The blade substrate 10 may be made of stainless steel, etc., and a sharp razor blade tip is formed.

The coating layer 20 is formed on the blade substrate 10 and is composed of plural coating regions with different properties. In the present disclosure, the coating layer may also be called a hard thin film layer or a hard coating layer. The coating layer tip (edge tip) is formed to surround the razor blade tip.

In another embodiment, the coating layer 20 may be formed with an asymmetrical thickness on the blade substrate 10. For example, in the blade substrate 10 shown in FIG. 1, the coating layer 20 may be formed with a greater thickness on the right side than on the left side of the blade substrate 10.

The lubricating layer 30 is formed on the coating layer 20 and may be formed in order to reduce the frictional force. The lubricating layer 30 may be made of a fluorine resin and may include, for example, polytetrafluoroethylene (PTFE).

The coating layer 20 may have an aspect ratio of 1:1.5 to 1:3.0, 1:1.8 to 1:2.6, or 1:2.0 to 1:2.4. According to the present disclosure, the aspect ratio of the coating layer 20 is implemented to be high so that the thickness of the blade substrate 10 may be made thinner.

Here, the aspect ratio of the coating layer 20 is defined as "a thickness (A) of the coating layer 20 at a distance 1 $\mu$m from the tip of the blade substrate (blade tip)": "a distance (B) from the tip of the blade substrate to the tip of the coating layer."

In addition, "the thickness (A) of the coating layer 20 at a distance 1 $\mu$m from the tip of the blade substrate (blade tip)" may be 200 nm to 600 nm, 300 nm to 500 nm, or 350 nm to 450 nm.

Hereinafter, the coating layer 20 according to the present disclosure will be described with reference to FIG. 2. FIG. 2 is a cross-section along A of FIG. 1, and the vertical direction in FIG. 2 is the thickness direction of the coating layer 20. In the drawings below, the thickness of the lubricating layer 30 is arbitrarily illustrated.

The coating layer 20 contains a first coating region 21 and a second coating region 22. One surface of the first coating region 21 is in contact with the blade substrate 10, and one surface of the second coating region 22 is in contact with the lubricating layer 30. In other embodiments, additional layers may be positioned between the first coating region 21 and the blade substrate 10 and/or between the second coating region 22 and the lubricating layer 30.

The coating layer 20 may be prepared by a CVD or PVD method.

The coating layer 20 may be formed using plasma, and the properties of the coating layer 20 may be adjusted by controlling the power density and/or bias voltage.

Whether there are nanocrystals or not and the size thereof may be adjusted by controlling energy during the formation process of the coating layer 20, for example, controlling the deposition rate (sputter power, bias, pressure, temperature, time, reactive gas, etc.).

The first coating region 21 has superior adhesive force compared to the second coating region 22, and the second coating region 22 has superior strength compared to the first coating region 21. In the present disclosure, the first coating region 21 and the second coating region 22 having different properties as described above are alternately formed at different depths.

The first coating region 21 contains a matrix-forming atom and a first atom, and the second coating region 22 contains a matrix-forming atom and a second atom. In addition, the first coating region 21 and the second coating region 22 may each comprise a small amount of additional atoms and impurities. Here, the small amount may be 5% by weight or less, 3% by weight or less, 1% by weight or less, or 0.1% by weight or less.

The matrix-forming atom may include at least one of Cr, Ti, Mo, and W. The matrix-forming atoms of the first coating region 21 and the second coating region 22 may be the same element.

The first atom may include at least one of C, B, N, and O, and the second atom may include at least one of C, B, N, and O. The first atom and the second atom may be different or the same element.

The second coating region 22 may have more nanocrystal regions than the first coating region 21, and the amount of the nanocrystal regions may be 3 to 50 times, 4 to 30 times, 15 to 25 times, or 3 to 10 times more.

Nanocrystals with diameters of 2nm, 3nm or 4nm or more may exist in the thin film. Nanocrystals may be measured at the middle depth region of the thin film (40 to 60% or 45 to 55% of the thickness, positions C and D in FIG. 2).

Nanocrystals may be analyzed using XRD and/or TEM.

X-ray diffraction may be used to diffract X-rays on the surface of a thin film to determine the degree of crystallinity of the thin film, i.e., the degree of nanocrystals or the nanocrystal region. In the case of amorphous phase with low crystallinity, a broad peak is formed, and in the case of high crystallinity, a material peak which has high intensity and is unique is observed. In the case of nanocrystals, a broad peak and a peak with a strong intensity exist at the same time, and in this case, it can be determined that nanocrystals are mixed in the amorphous phase.

In the case of TEM, when a specimen measured by XRD is analyzed in detail, there are sections where millet shape crystals exist regularly in the amorphous phase, and these can be determined as nanocrystals.

In the case where the first atom and the second atom are different elements, the second coating region 22 may also contain a small amount of the first atom, and the first coating region 21 may also contain a small amount of the second atom.

In this case, the first coating region 21 contains more moles of the first atom than the second atom, and the second coating region 22 contains more moles of second atom than first atom.

In the first coating region 21, the number of moles of the first atoms may be 1.0 to 10.0 times, 1.5 to 8.0 times, or 2.0 to 4.0 times that of the second atoms.

In the second coating region 22, the number of moles of the second atom may be 1.5 to 10 times, 2.0 to 15.0 times, or 4.0 to 12.0 times that of the first atom.

In the first coating region 21, the first atom may be contained more in the middle depth region than the boundary region between both regions 21 and 22, and in the second coating region 22, the second atom may be contained more in the middle depth region than the boundary region between both regions 21 and 22.

In the case where the first atom and the second atom are different, the amount of the matrix atom may be 1.1 to 2.0 times, 1.2 to 1.8 times, or 1.3 to 1.6 times higher in the first coating region 21 than in the second coating region 22 on a molar basis.

Specifically, the first coating region 21 may contain 75 to 80 atomic % of a matrix-forming atom, 10 to 20 atomic % of a first atom, and 1 to 10 atomic % of a second atom, and the second coating region 22 may contain 50 to 60 atomic % of a matrix-forming atom, 1 to 10 atomic % of a first atom, and 35 to 45 atomic % of a second atom. In addition, the entire coating layer 20 may contain 65 to 75 atomic % of a matrix-forming atom, 5 to 17 atomic % of a first atom, and 12 to 23 atomic % of a second atom.

The thickness of each region of the first coating region 21 and the second coating region 22 may be 5 to 300 nm, 10 to 200 nm, 10 to 150 nm, or 15 to 150 nm.

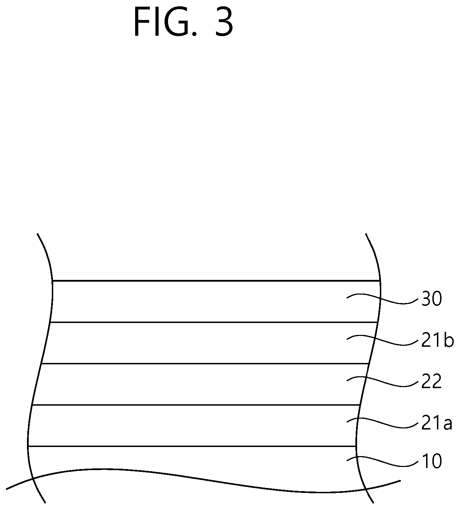

The configuration of the coating layer 20 described above may be variously changed. In particular, the number, thickness, etc. of the first coating region 21 and the second coating region 22 may be variously changed, and this will be described with reference to FIGS. 3 to 5. FIGS. 3 to 5 show modified examples of the coating layer in a razor blade according to one embodiment of the present disclosure.

In the modified example of FIG. 3, two first coating regions 21a and 21b are provided, and a second coating region 22 is provided between the first coating regions 21a and 21b.

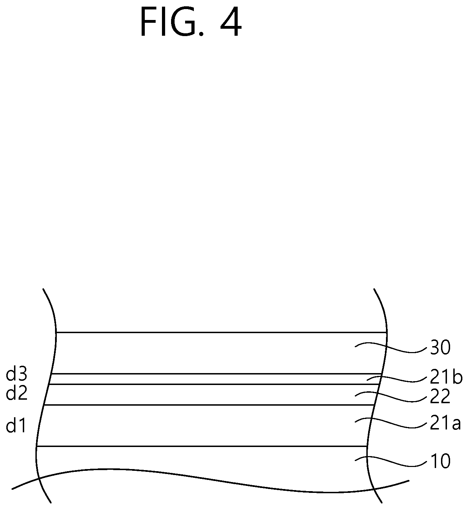

In the modified example of FIG. 4, the configuration of the coating layer 20 is the same as that of the modified example of FIG. 3, but the thickness d1 of the first coating region 21a at the lower part is formed to be larger than the thickness d2 of the second coating region 22, and the thickness d3 of the first coating region 21b at the upper part is formed to be smaller than the thickness d2 of the second coating region 22.

The thickness d1 of the first coating region 21a at the lower part, i.e., the first coating region 21a not in contact with the lubricating layer 30, may be 1.5 to 3.0 times or 1.8 to 2.5 times the thickness d2 of the adjacent second coating region 22.

On the other hand, the thickness d5 of the first coating region 21b in contact with the lubricating layer 30 may be 0.25 to 0.60 times or 0.30 to 0.45 times the thickness d2 of the adjacent second coating region 22.

The thickness d3 of the first coating region 21b located at the outermost part of the coating layer 20, i.e., the region in contact with the lubricating layer 30, may be 0.05 to 0.70 times, 0.10 to 0.50 times, or 0.15 to 0.25 times the thickness d1 of the first coating region 21a in contact with the lubricating layer 30.

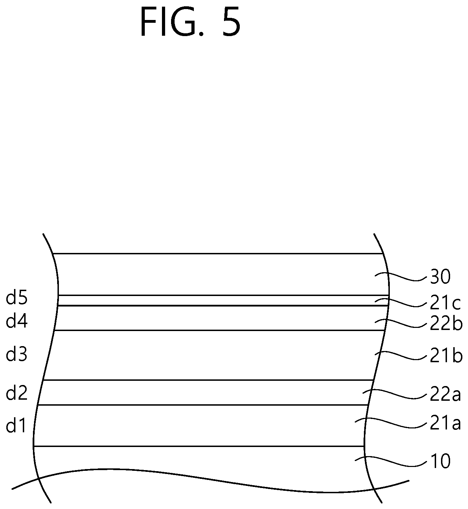

In the modified example of FIG. 5, first coating regions 21a, 21b, and 21c are provided with three layers, and second coating regions 22a and 22b are provided with two layers.

The first coating regions 21a, 21b, and 21c and the second coating regions 22a and 22b are formed alternately, and the first coating regions 21a and 21c are located at both ends.

The average thickness of the first coating regions 21a, 21b, and 21c may be 0.3 to 0.8 times, 0.5 to 0.8 times, 0.9 to 1.1 times, 0.8 to 1.2 times, 1.1 to 3.0 times, 1.3 to 2.4 times, or 1.6 to 2.1 times the average thickness of the second coating regions 22a and 22b.

The smaller the thickness of each region and the greater the number of repetitions, the durability may be increased. With respect to the number of repetitions, each region 21 and 22 may be provided with 2 to 10, 2 to 8, or 4 to 6, respectively but is not limited to.

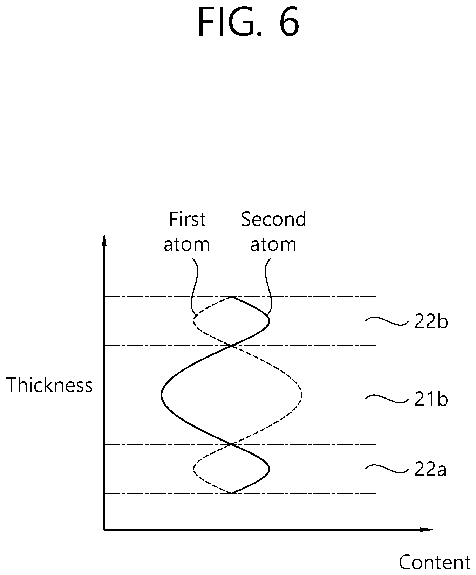

FIG. 6 shows the change in the content of the first atom and the second atom in a part of the coating layer 20 shown in FIG. 5. FIG. 6 shows the change in the content in three regions 22a, 21b, and 22b located in the middle of the coating layer 20.

The component ratio of the first atom and the second atom, the amount of the first atom, and/or the amount of the second atom gradually change depending on the thickness of the coating layer 20. Here, the 'gradual' change means that the component ratio and the content change in a continuous form depending on the thickness, that is, there is no stepwise change or discontinuous change. This is because there is no distinct boundary between the regions 21 and 22 of the coating layer 20 of the present disclosure and the transition between them occurs continuously, not in a discrete or layered manner.

For example, the coating layer 20 according to the present disclosure may be formed through a single process in a single plasma chamber, or may be formed through a stepwise process in which one region is formed through a first process in the single plasma chamber and the other region is formed through a second process separated from the first process. This is distinguished from the method in which one region is formed in a first plasma chamber and the other region is formed in a second plasma chamber that is different from the first plasma chamber.

In addition, since the coating layer 20 according to the present disclosure is formed in the single plasma chamber, a small or trace amount of the second atom exists also in the central region of the first coating region 21 and a small or trace amount of the first atom exists also in the central region of the second coating region 22.

As shown in FIG. 6, the first atom and the second atom may have a different sine wavelike concentration distribution depending on the thickness. The first atom shows the highest molar content in the middle depth region of the first coating region 21b, and the second atom shows the highest molar content in the middle depth region of the second coating regions 22a and 22b.

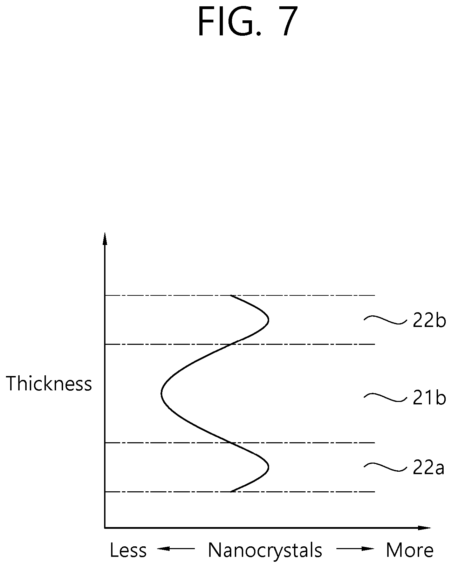

FIG. 7 shows a distribution of nanocrystals in the coating layer shown in FIG. 5, and shows a change in the size (area) of the nanocrystal region in a part of the coating layer 20 shown in FIG. 5. FIG. 7 shows a change in the size of the nanocrystal region in three regions 22a, 21b, and 22b located in the middle of the coating layer 20.

The nanocrystal region may appear highest peak in the middle depth region of the second coating regions 22a and 22b.

The size of the nanocrystal region may also gradually change depending on the thickness of the coating layer 20, just like the composition ratio, and the physical properties of the coating layer 20 such as at least one of strength and adhesive properties may also gradually change depending on the thickness of the coating layer 20.

According to the present disclosure described above, the first coating region 21 with excellent adhesive properties and the second coating region 22 with excellent strength may be alternately laminated and used to implement high durability while having excellent adhesive properties. In particular, even if the thin film is formed thickly to improve the durability of the thin blade, the thin film strength can be adjusted and the edge shape can be maintained.

In particular, the configuration and effect of the coating layer 20 in which the matrix-forming atom includes Cr, the first atom includes C, and the second atom includes B are described in detail as follows.

According to the present disclosure, a first coating region 21 and a second coating region 22 are formed in the coating layer 20 as the concentrations of carbon and boron are alternated along the thickness direction of the coating layer 20, and the first coating region 21 and the second coating region 22 complement each other's shortcomings.

Since the first coating region 21 has more excellent adhesive properties than the second coating region 22, it is effective to have the first coating region 21 located at both ends of the coating layer 20. The second coating region 22 with high hardness is located inside the coating layer 20 to improve durability. That is, the ductile region and the brittle region alternately exist depending on the thickness of the coating layer 20 so that the external impact absorption effect increases and the durability of the coating layer 20 is improved. In addition, since the edge shape, such as the thickness or tip radius of the edge tip portion of FIG. 1, is easily controlled, the cutting force is improved and it is also effective in reducing skin irritation.

Hereinafter, the present disclosure will be described in detail through Experimental Examples.

**1. Manufacturing of a razor blade**

A coating layer was formed by the sputtering method among PVD methods. Chromium was used as the matrix-forming atom, carbon was used as the first atom, and boron was used as the second atom. The blade substrate was made of stainless steel, and the lubricating layer was formed of PTFE.

In the formation of the coating layer, at least one of a DC power and an RF power was applied to a CrCB target to form a thin film (coating layer), and the substrate (blade substrate) was formed with a negative bias voltage ranging, more specifically, from -800 V to 0 V. The temperature of the substrate was 25 to 450°C. An argon gas was used when forming the thin film.

A sputter target composed of a mosaic type of CrCB was used as the CrCB target. The pressure was $1.0 \times 10^{-3}$ to $2.0 \times 10^{2}$ Torr.

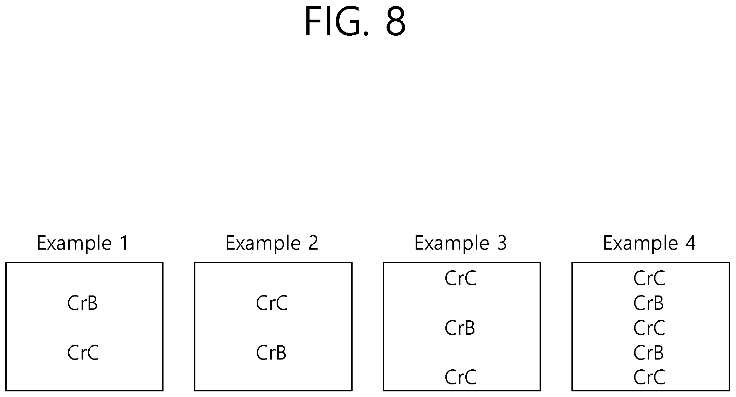

Razor blades of four different examples having a cross-sectional structure similar to that of FIG. 8 were manufactured.

In FIG. 8, the lower part is a part that contacts the blade substrate, and the upper part is a part that contacts the lubricating layer.

In FIG. 8, "CrC" corresponds to the first coating region and may also be expressed as C-rich or C. "CrB" corresponds to the second coating region and may also be expressed as B-rich or B.

The CrC region contains boron, and the CrB region also contains carbon.

That is, Example 1 is a double region structure of the first coating region-second coating region (C-B), Example 2 is a double region structure of the second coating region-first coating region (B-C), Example 3 is a triple region structure of the first coating region-second coating region-first coating region (C-B-C), Example 4 is a quintuplex region structure of the first coating region-second coating region-first coating region-second coating region-first coating region (C-B-C-B-C), and the region mentioned first in each Example is a region that is in contact with or adjacent to the blade substrate.

In each Example, the coating layer was formed symmetrically on the blade substrate.

**2. Analysis of the razor blade**

In Example 1, the closer to the blade substrate, the higher the specific gravity of CrC, and the farther away from the blade substrate, the higher the specific gravity of CrB.

The C-rich region close to the substrate may form a thin film adhesive section by controlling the crystallization of Cr by relatively increasing the concentration of carbon, thereby improving the adhesive force between the substrate and the coating layer.

As it gets farther away from the substrate, the concentration of boron is gradually increased (i.e., as the concentration of boron increases, the concentrations of carbon and Cr decrease) to form small and dense CrB nanocrystals of about 5 nm or less, thereby improving the strength of the thin film.

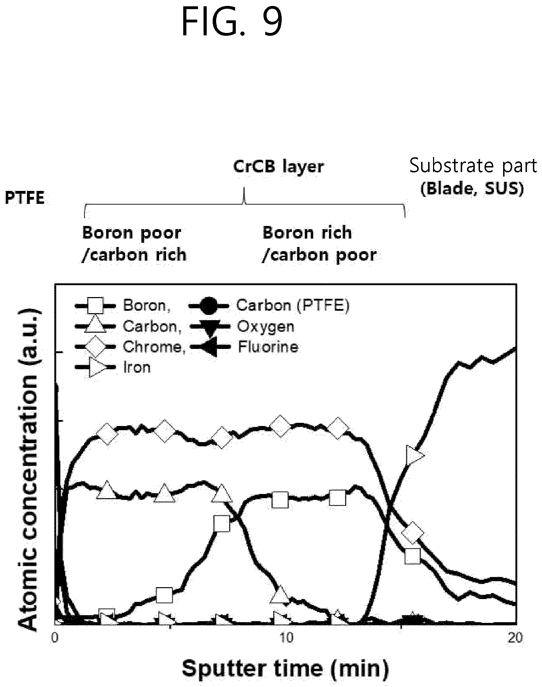

FIG. 9 shows atomic concentrations of major atoms measured depending on the thickness of the coating layer for the razor blade of Example 2. FIG. 9 was measured using AES, and the sputtering time is a time required for etching through sputtering of using argon ions during the AES measurement, which is proportional to the thickness of the coating layer.

The shaving blade needs to be processed thin enough to improve cutting performance, and accordingly its durability may be rapidly reduced. In Example 2, the durability of the blade was improved by arranging the B-rich region adjacent to the substrate in order to compensate for this.

In Example 2, CrC is provided in a region far from the substrate. That is, since the CrC region is in contact with the lubricating layer, the adhesive force with the lubricating layer is improved.

Compared to Example 1, Example 3 is further provided with a CrC region in a region adjacent to the lubricating layer. Materials that adhere to a thin film(ex. Cr, Ni, Ti, Mo, etc.) such as Cr are used to improve the adhesive force with the substrate bonding material and the lubricating layer by the material's unique characteristics and characteristics such as the stress, surface energy, etc. due to these characteristics. According to Example 3, both the durability improvement by CrB and the adhesive force improvement by CrC may be obtained.

In Example 4, the thin film characteristics may be further improved by providing plural CrB and CrC regions repeatedly.

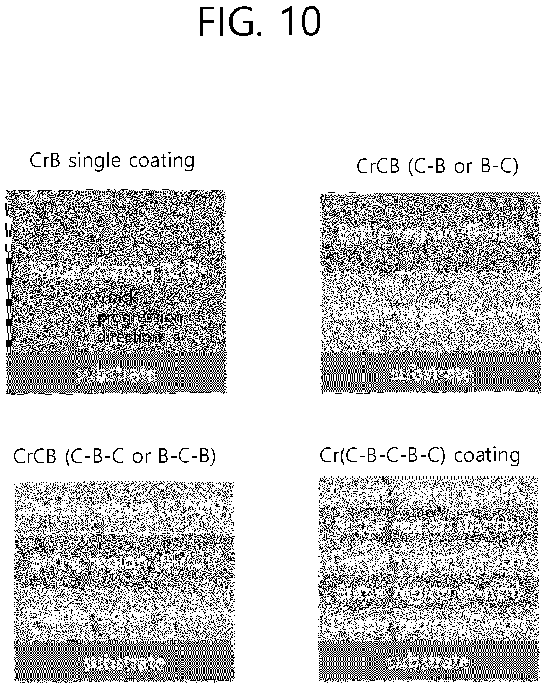

FIG. 10 shows destruction mechanisms of the coating layer. A coating that contains only a brittle region such as a CrB region causes cracks to occur immediately when an external impact is applied, and the coating is damaged. If a ductile region such as a CrC region is added, the CrC region may buffer the external impact. As in Example 4, the more plural brittle and ductile regions are repeated, the more the impact is dispersed efficiently and crack occurrence may be suppressed.

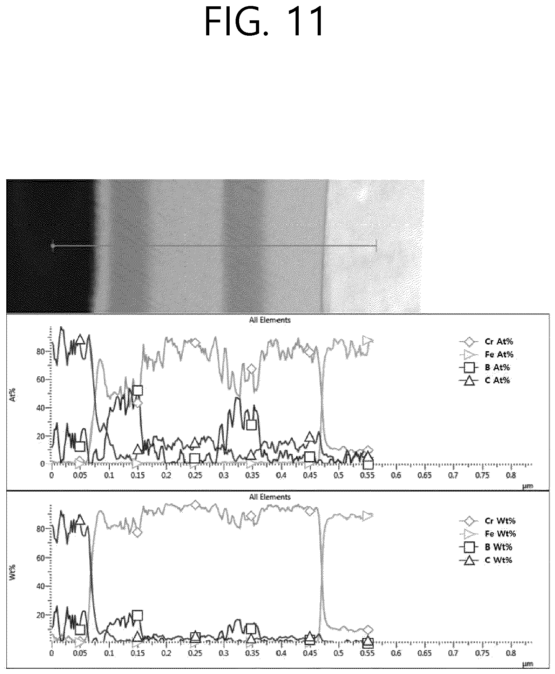

FIG. 11 shows a TEM image and components depending on the thickness as atomic ratio and mass ratio for the coating layer of Example 4. FIG. 11 shows results measured using TEM-EDS.

The atomic ratio of each region is as follows.

C-rich region atomic ratio: 80 atomic % of Cr / 15 atomic % of C / 5 atomic % of B
B-rich region atomic ratio: 55 atomic % of Cr / 5 atomic % of C / 40 atomic % of B
Entire coating layer atomic ratio: 71 atomic % of Cr / 11.5 atomic % of C / 17.25 atomic % of B

The mass ratio of each region is as follows.

C-rich region mass ratio Cr: C = 95 weight % : 4 weight %
B-rich region mass ratio Cr: B = 85 weight % : 13 weight %
Entire coating layer mass ratio Cr: C: B = 92 weight % : 3.4 weight % : 4.6 weight %

The B-rich region was designed to have a high B content and a low Cr content in order to have high hardness, and the C-rich region was designed to have a relatively high Cr content in order to have ductility and adhesive force.

In Example 4, the total thickness of C-B-C-B-C was approximately 373 nm, and the thickness of each region was 97 nm (C, d1 in FIG. 5) - 65.3 nm (B, d2 in FIG. 5) - 121 nm (C, d3 in FIG. 5) - 65.3 nm (B, d4 in FIG. 5) - 24.3 nm (C, d5 in FIG. 5) from the region located at the lower part. The coating layer may grow at an angle of 55 to 75 degrees or 60 to 70 degrees with respect to the substrate, and the growth angle in Example 4 was 65 degrees.

In Example 4, the thickness ratio of the regions was approximately 65% for the CrC region and approximately 35% for the CrB region.

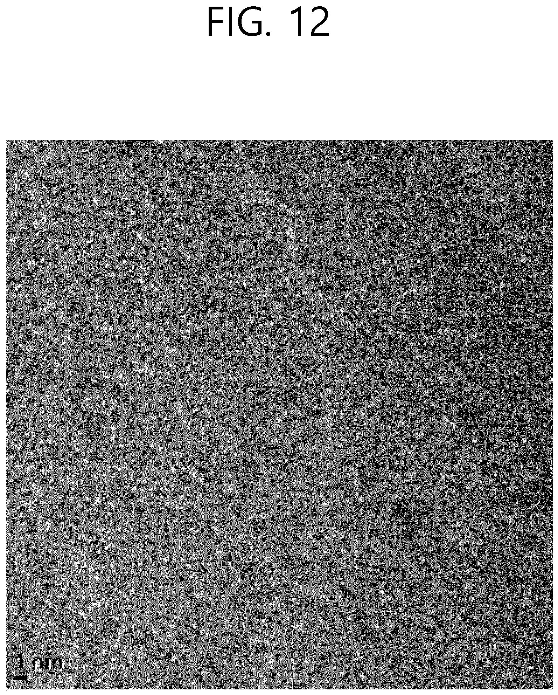

FIG. 12 shows a result of analyzing the nanocrystals of the CrB region in Example 4 using TEM. TEM was measured at the middle depth of the corresponding region.

The region of the nanocrystals in the CrB region shown through FIG. 12 is approximately 10%, and the size is 1nm to 10 nm.

The aspect ratio, which is the ratio of thickness of the coating layer at a distance 1 $\mu$m from the tip of the blade substrate and from the tip of the blade substrate to the tip of the coating layer in Example 4 was measured as 1:2.2.

### 3. Performance Experiment of Razor Blades

Performance experiments were conducted on razor blades according to Examples 1 to 4. Performance experiments were also conducted on Examples composed of C-B-C-B and B-C-B-C in addition to Examples 1 to 4, and razor blades having a CrB single coating or a CrC single coating formed thereon.

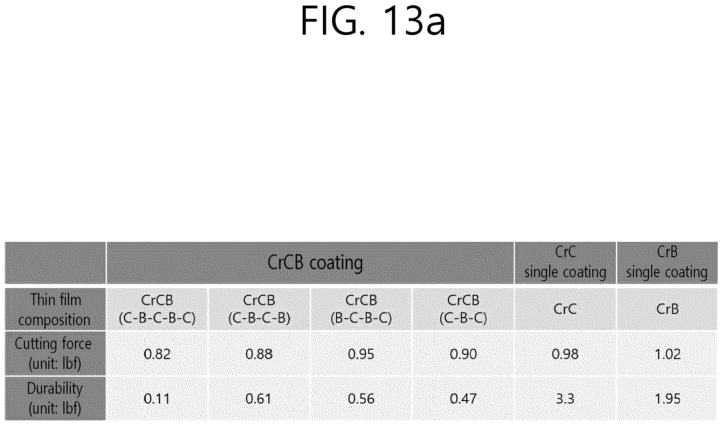

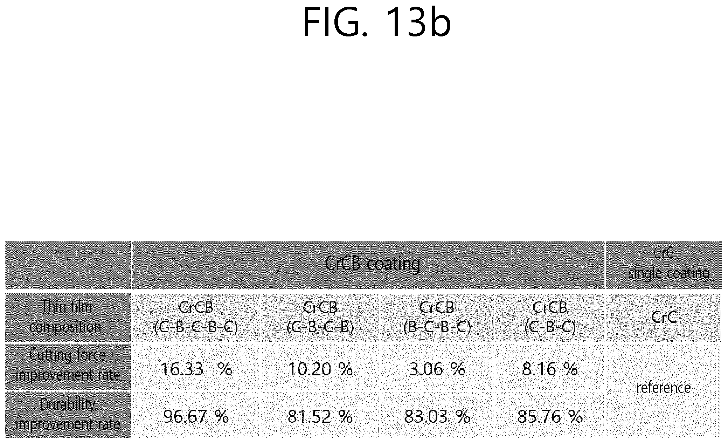

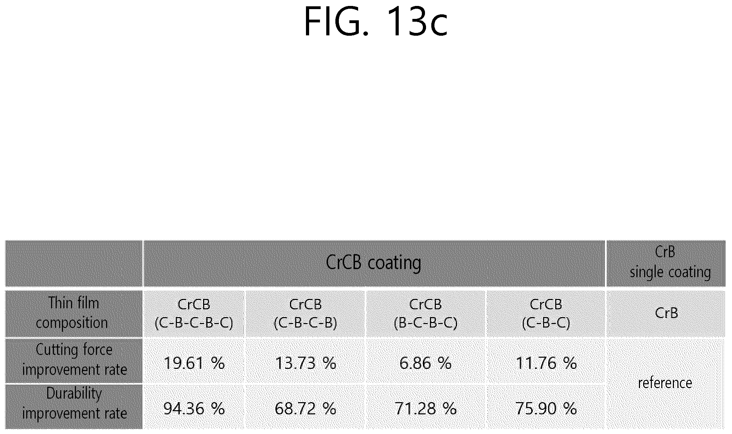

FIGS. 13A to 13C show experimental results for cutting force and durability. FIG. 13A is raw data, FIG. 13B shows performance improvement rates based on the CrC single coating, and FIG. 13C shows performance improvement rates based on the CrB single coating.

For example, the performance improvement rates were calculated as follows for cutting force based on the CrC single coating.

(Cutting force of the CrC single coating - Cutting force of CrCB) / Cutting force of the CrC single coating * 100

A wet wool felt, which is commonly used in the razor blade field, was used as a cutting target used in the repeated cutting experiment for testing the coating performance. The cutting properties were evaluated as the lowest value after cutting the cutting material 5 times, and a lower value means that the load (force) is less when cutting the hair, allowing for a smooth shave without snagging. Durability was evaluated by the difference in cutting force of the wool felt before and after the Velcro test when the wool felt was cut 5 times, the Velcro test was performed, and the wool felt was cut 5 times again. In other words, the corresponding value means a difference value ($\Delta$) between the cutting force of the wool felt before the Velcro test and the cutting force of the wool felt after the Velcro test. The Velcro test is to push and cut Velcro, which has a much greater cutting load than a beard, a certain distance as if shaving, and through this, the durability of the edge in a harsher environment can be evaluated.

Table 1 shows results of measuring the repeated durability of hair.

The repeated durability test is a test that repeatedly cuts wet hair at the same point of the blade, and is a method of evaluating durability by the number of times until the edge is destroyed and the hair is not cut.

The CrCB coating refers to the CrCB coating of Example 4. The same substrate and the same coating thickness were used for the CrB single coating and the CrCB coating, and plural tests were performed for each of the two coatings.

<Table 1>

| Coating Type | Number of repetitions |
|---|---|
| CrCB coating (Example 4) | 6,200 cycles or more |
| CrB single coating | Edge destruction occurs at approximately 3,500 cycles or more |

The CrB single coating showed that edge destruction occurred at approximately 3,500 cycles on average, while the CrCB coating showed that it could be used to cut up to approximately 6,200 cycles or more. In the test of the CrCB coating, it was determined that 6,200 cycles exceeded the performance level required for actual shaving, so the test was terminated at 6,200 cycles.

**Claims**

1. A razor blade comprising:

    a blade substrate having a blade edge formed therein; and
    a coating layer formed on the blade substrate,
    wherein the coating layer contains a matrix-forming atom, a first atom, and a second atom, the coating layer contains a first coating region and a second coating region located at different depths in the thickness direction, and the second coating region has larger area of nanocrystal regions than the first coating region.

2. The razor blade of claim 1, wherein the first coating region has superior adhesive force compared to the second coating region, and the second coating region has superior strength compared to the first coating region.

3. The razor blade of claim 1, wherein the matrix-forming atom includes at least one of Cr, Ti, Mo, and W, the first atom includes at least one of C, B, N, and O, and the second atom includes at least one of C, B, N, and O.

4. The razor blade of claim 3, wherein the first atom and the second atom are the same element.

5. The razor blade of claim 3, wherein the first atom and the second atom are different elements, the first coating region contains more moles of the first atom than the second atom, and the second coating region contains more moles of the second atom than the first atom.

6. The razor blade of claim 3, wherein at least one of the first coating region and the second coating region comprises two regions spaced apart from each other, and the first coating region and the second coating region are alternately arranged.

7. The razor blade of claim 6, wherein the first coating region and the second coating region are each provided as at least two regions spaced apart from each other.

8. The razor blade of claim 6, wherein one of the first coating region is formed closest to the blade substrate among the first coating region and the second coating region.

9. The razor blade of claim 7, wherein in the first coating region, the number of moles of the first atom is 1.5 to 8 times that of the second atom, and in the second coating region, the number of moles of the second atom is 2 to 15 times that of the first atom.

10. The razor blade of claim 9, wherein the amount of the matrix-forming atom is 1.2 to 1.8 times higher in the first coating region than in the second coating region on a molar basis.

11. The razor blade of claim 6, wherein the second coating region has 3 to 50 times more nanocrystals than the first coating region.

12. The razor blade of claim 6, wherein the first coating region is provided as plural regions spaced apart from each other, and the thickness of the first coating region adjacent to the blade substrate is 1.8 to 2.5 times the thickness of the second coating region that is in contact with the first coating region adjacent to the blade substrate.

**13.** The razor blade of claim 6, wherein the first coating region is located at an outermost part of the coating layer, and the thickness of the first coating region located at the outermost part of the coating layer is 0.1 to 0.5 times the thickness of the first coating region located inside the coating layer.

**14.** The razor blade of claim 6, wherein the matrix-forming atom includes Cr, the first atom includes C, and the second atom includes B.

**15.** The razor blade of claim 6, wherein the coating layer has an aspect ratio of 1:1.8 to 1:2.6, and the aspect ratio is defined as thickness of the coating layer at a distance 1 $\mu$m from the tip of the blade substrate to distance from the tip of the blade substrate to the tip of the coating layer.

# FIG. 1

1

Edge
tip

B

Blade
tip

1 μm

A

10          20

# FIG. 2

Thickness direction

C

D

30
22
21
10

# FIG. 3

30
21b
22
21a
10

# FIG. 4

# FIG. 5

# FIG. 6

# FIG. 7

# FIG. 8

EP 4 667 619 A1

| Example 1 | Example 2 | Example 3 | Example 4 |
|-----------|-----------|-----------|-----------|
| CrB | CrC | CrC | CrC |
| | | | CrB |
| CrC | CrB | CrB | CrC |
| | | | CrB |
| | | CrC | CrC |

# FIG. 9

# FIG. 10

CrB single coating

CrCB (C-B or B-C)

CrCB (C-B-C or B-C-B)

Cr(C-B-C-B-C) coating

# FIG. 11

# FIG. 12

# FIG. 13a

EP 4 667 619 A1

| | CrCB coating | | | | CrC single coating | CrB single coating |
|---|---|---|---|---|---|---|
| Thin film composition | CrCB (C-B-C-B-C) | CrCB (C-B-C-B) | CrCB (B-C-B-C) | CrCB (C-B-C) | CrC | CrB |
| Cutting force (unit: lbf) | 0.82 | 0.88 | 0.95 | 0.90 | 0.98 | 1.02 |
| Durability (unit: lbf) | 0.11 | 0.61 | 0.56 | 0.47 | 3.3 | 1.95 |

# FIG. 13b

| Thin film composition | CrCB coating | | | | CrC single coating |
|---|---|---|---|---|---|
| | CrCB (C-B-C-B-C) | CrCB (C-B-C-B) | CrCB (B-C-B-C) | CrCB (C-B-C) | CrC |
| Cutting force improvement rate | 16.33 % | 10.20 % | 3.06 % | 8.16 % | reference |
| Durability improvement rate | 96.67 % | 81.52 % | 83.03 % | 85.76 % | |

# FIG. 13c

EP 4 667 619 A1

| Thin film composition | CrCB coating | | | | CrB single coating |
|---|---|---|---|---|---|
| | CrCB (C-B-C-B-C) | CrCB (C-B-C-B) | CrCB (B-C-B-C) | CrCB (C-B-C) | CrB |
| Cutting force improvement rate | 19.61 % | 13.73 % | 6.86 % | 11.76 % | reference |
| Durability improvement rate | 94.36 % | 68.72 % | 71.28 % | 75.90 % | |

Europäisches
Patentamt

European
Patent Office

Office européen
des brevets

# EUROPEAN SEARCH REPORT

**Application Number**

EP 25 18 2049

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/022996 A1 (PARK MIN JOO [KR] ET AL) 26 January 2023 (2023-01-26) | 1-4, 6-13,15 | INV. |
| A | * paragraphs [0051] - [0068]; claims 1-9 * | 5,14 | C23C28/04 |
| | ----- | | B26B21/60 |
| X | US 2020/368929 A1 (PARK MIN JOO [KR] ET AL) 26 November 2020 (2020-11-26) | 1-4 | C23C14/06 C23C16/32 |
| A | * paragraphs [0012], [0013], [0038], [0039], [0049], [0057], [0064], [0066]; claims 1-16 * | 5-15 | C23C16/38 C23C30/00 C23C28/00 |
| | ----- | | |
| A | US 2023/311352 A1 (LEE HYUN JU [KR] ET AL) 5 October 2023 (2023-10-05) * paragraphs [0097] - [0112]; figure 5 * | 1-15 | |
| | ----- | | |
| A | US 2022/134588 A1 (ZHUK ANDREW VLADIMIROVICH [US] ET AL) 5 May 2022 (2022-05-05) * claims 1-44 * | 1-15 | |
| | ----- | | |

| | |
|---|---|
| | **TECHNICAL FIELDS SEARCHED (IPC)** |
| | C23C B26B |

The present search report has been drawn up for all claims

| Place of search | Date of completion of the search | Examiner |
|---|---|---|
| The Hague | 5 August 2025 | Chalaftris, Georgios |

EPO FORM 1503 03.82 (P04C01)

## ANNEX TO THE EUROPEAN SEARCH REPORT
## ON EUROPEAN PATENT APPLICATION NO.

EP 25 18 2049

This annex lists the patent family members relating to the patent documents cited in the above-mentioned European search report.
The members are as contained in the European Patent Office EDP file on
The European Patent Office is in no way liable for these particulars which are merely given for the purpose of information.

05-08-2025

| Patent document cited in search report | Publication date | Patent family member(s) | | Publication date |
|---|---|---|---|---|
| US 2023022996 A1 | 26-01-2023 | EP | 3741525 A1 | 25-11-2020 |
| | | KR | 20200134526 A | 02-12-2020 |
| | | US | 2020368928 A1 | 26-11-2020 |
| | | US | 2023022996 A1 | 26-01-2023 |
| | | US | 2024375304 A1 | 14-11-2024 |
| US 2020368929 A1 | 26-11-2020 | EP | 3741524 A1 | 25-11-2020 |
| | | KR | 20200134527 A | 02-12-2020 |
| | | US | 2020368929 A1 | 26-11-2020 |
| | | US | 2023138439 A1 | 04-05-2023 |
| | | US | 2024083058 A1 | 14-03-2024 |
| | | US | 2025010504 A1 | 09-01-2025 |
| US 2023311352 A1 | 05-10-2023 | EP | 4166291 A1 | 19-04-2023 |
| | | KR | 20210155639 A | 23-12-2021 |
| | | KR | 20230047986 A | 10-04-2023 |
| | | US | 2023311352 A1 | 05-10-2023 |
| | | WO | 2021256728 A1 | 23-12-2021 |
| US 2022134588 A1 | 05-05-2022 | CA | 3199444 A1 | 12-05-2022 |
| | | CN | 116615318 A | 18-08-2023 |
| | | EP | 4240567 A2 | 13-09-2023 |
| | | US | 2022134588 A1 | 05-05-2022 |
| | | WO | 2022098615 A2 | 12-05-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 102211395